(19) Europäisches Patentamt
European Patent Office
Office européen des brevets

(11) Publication number : **0 453 126 A2**

(12) # EUROPEAN PATENT APPLICATION

(21) Application number : 91302916.1

(51) Int. Cl.[5] : G03F 7/033

(22) Date of filing : 03.04.91

(30) Priority : 04.04.90 US 504500

(43) Date of publication of application : 23.10.91 Bulletin 91/43

(84) Designated Contracting States : DE FR GB IT NL

(71) Applicant : HOECHST CELANESE CORPORATION
Route 202-206 North
Somerville, New Jersey (US)

(72) Inventor : Khanna, Dinesh N.
39 Musket Road
West Warwick, Rhode Island (US)
Inventor : Mueller, Werner H.
13825 Eaglesnest Bay Drive
Corpus Christi, Texas (US)

(74) Representative : De Minvielle-Devaux, Ian Benedict Peter et al
CARPMAELS & RANSFORD 43, Bloomsbury Square
London WC1A 2RA (GB)

(54) **Negative photoresist developable in aqueous base.**

(57) The present invention provides for a negative acting photoresist composition exhibiting excellent contrast and sensitivity in the broad band and deep UV band of the spectrum comprising a mixture of an alkali soluble polymeric binder material, a photoinitiator and a photopolymerizable compound containing at least two terminal ethylenically unsaturated groups. The polymeric binder material is essentially free of ethylenic unsaturation or other substituent groups which will react with the photopolymerizable compound when exposed to light in the presence of the photoinitiator. The composition of this invention when formed into a film provides negative photoresist coatings which cure rapidly under exposure to actinic radiation to form an insoluble, interpenetrating resinous network in the exposed areas but which are stable and retain their solubility in alkaline developers in unexposed areas.

EP 0 453 126 A2

## Background of the Invention

### 1. Field of the Invention

The present invention relates to negative photoresist compositions sensitive in the deep and near UV range of the spectrum based on a mixture of an alkali soluble polymer, a photopolymerizable material and a photoinitiator.

### 2. Description of Related Art

Photoresists are materials which change their solubility in a developer solution after the photoresist has been exposed to actinic radiation, such as to ultraviolet radiation. Photoresist compositions comprise a photosensitive compound (hereafter sometimes called a photoinitiator), a film forming polymeric resin and a solvent. There are other types of compositions possible, such as a photosensitizer dissolved in an appropriate solvent. The photoresist composition is applied to a substrate which is to be patterned and the solvent is then removed, as with heat, leaving the photoresist as a thin film covering the substrate. As a consequence of the exposure to radiation of the photoresist, a different solubility rate results between the exposed and unexposed (masked over) portions of the resist film which yields a surface relief pattern after development. Those photoresists which become more soluble in a developer solution in the exposed regions are referred to as "positive" photoresists. Those which become less soluble in the exposed regions are referred to as "negative" photoresists. The present invention deals with a class of those compounds suitable for use in negative photoresist compositions.

Positive photoresists may typically comprise an aqueous alkali soluble resin, such as novolac resin or poly(p-hydroxystyrene), and a diazonaphthoquinone sulfonic acid ester sensitizer. The resin and sensitizer are applied such as by spin coating, spray coating, or other suitable means from an organic solvent or solvent mixture onto a substrate, such as a silicon wafer or a chrome-plated glass plate. The developer used to process the positive photoresists are aqueous alkaline solutions, such as sodium metasilicate, potassium hydroxide, tetramethyl ammonium hydroxide and ammonium hydroxide. The developer removes the areas of the coated photoresist film that have been exposed to light or other form of irradiation so as to produce a relief pattern in the photoresist film.

Negative photoresists generally comprise a polymer binder system which undergoes photopolymerization or crosslinking under the influence of actinic light thereby rending the exposed areas less soluble in aqueous or organic solvent-based developers.

The application of a photosensitive film to various substrates is an essential step in the fabrication of integrated circuits. The substrates are generally silicon wafers which may have a thin oxide coating or other coating such as silicon nitride or aluminum. The photosensitive film is used to pattern the substrate in a series of steps including exposure (through a mask pattern), development to yield a relief pattern in the resist layer and a substrate etch step to transfer that pattern into the substrate material. It is essential that the mask pattern be accurately reproduced in the substrate etch pattern. To achieve this high degree of accuracy, the mask pattern must be well resolved by the photoresist layer. The laws of optics and diffraction dictate that resolution will improve as the wavelength of the irradiation is shortened. Thus, photoresists capable of operating in the deep ultraviolet (DUV) region (200-300nm) will be capable of higher potential resolution than those resists limited to operating in the near ultraviolet (NUV) region (300-400nm). Conventional photoresists employing novolac resins as the alkali soluble, film forming polymers are highly absorbing in the DUV region in films of approximately one micron thickness and so are not preferred for use in that region. Diazonaphthoquinone sulfonic acid esters are commonly used as sensitizers in conventional NUV photoresists. While these ester sensitizers are photoactive in the DUV, they exhibit several serious limitations for use as DUV photosensitizers. These sensitizers exhibit intense absorptions in the DUV region, making the resist composition excessively absorptive as well. These DUV absorptions are also poorly photobleached by the exposing radiation so that the film's absorbance is not greatly diminished during the irradiation process. Ideally, the sensitizer photoproduct should be nonabsorbing in the region of irradiation used to expose the resist so that all absorbed light does useful chemistry, thereby maximizing sensitivity. These prior art sensitizers also possess NUV absorption bands which allow them to be used in conventional NUV photoresists. However, this NUV response would be considered a drawback in a true DUV resist, as it would necessitate filtering the exposure source to remove long wavelength radiation to prevent degradation of the resolution.

Negative resist compositions based on a mixture of a base-developable binder resin such as poly p-hydroxystyrene are known in the art. For example, US Patent 4,800,152 discloses a crosslinkable system based on a mixture of poly p-hydroxystyrene, a source of polyfunctional carbonium ions such as tris-acetoxymesitylene and an onium salt which generates an acid when exposed to actinic radiation. US Patent 4,491,628 discloses a resist composition based on a blocked polymer such as p-tert-butoxycarbonyloxystyrene or poly(tert-butyl p-vinylbenzoate) and a photoinitiator which generates an acid upon exposure to light. The acid labile pendant groups are cleaved upon exposure of the system to actinic radiation, which renders the polymer more soluble in aqueous alkaline developer solutions in the exposed areas. Positive or negative images may be made depending on the developer solution employed.

US Patent 4,659,649 discloses negative-acting photosensitive compositions based on a cationically curable resin such as an epoxy resin and a material which generates an acid upon exposure to light such as an onium salt. The generated acid serves to catalyze the crosslinking of the curable resin in areas exposed to light. Copending application S.N. 07/405,493, filed September 11, 1989 discloses base-developable negative acting photoresist compositions base on an alkali-soluble, hydroxy-substituted polyamide or polyimide polymer, a photopolymerizable material containing at least two ethylenically-unsaturated double bonds and a photoinitiator.

While these and other systems are generally suitable for their intended purposes, they are generally limited in terms of the spectral absorbancy of the polymer binder and photosensitive components employed in the system, as pointed out above. Also, there exists a continuing need to provide photoresist materials having excellent contrast, the ability to reproduce fine line structures of less than 2 microns, sensitivity in the broad band and deep UV band of the spectrum and good adhesion to substrates over which they are applied.

## SUMMARY OF THE INVENTION

The present invention provides for a negative acting photoresist composition exhibiting excellent contrast and sensitivity in the broad band and deep UV band of the spectrum comprising a mixture of an alkali soluble polymeric binder material, a photoinitiator and a photopolymerizable compound containing at least two terminal ethylenically unsaturated groups. The polymeric binder material is essentially free of ethylenic unsaturation or other substituent groups which will react with the photopolymerizable compound when exposed to light in the presence of the photoinitiator. The composition of this invention when formed into a film provides negative photoresist coatings which cure rapidly under exposure to actinic radiation to form an insoluble, interpenetrating resinous network in the exposed areas but which are stable and retain their solubility in alkaline developers in unexposed areas.

## DETAILED DESCRIPTION OF THE INVENTION

Polymer materials useful as binder resins in the photoresist compositions of this invention include resins which, when formed into thin films are soluble in aqueous alkali developer solutions. Preferred polymer materials are those which are non-absorbing in the broad band or deep UV range of the energy source used to expose the resist and which are free of ethylenic unsaturation and substituent groups which are capable of reacting with he ethylenically unsaturated crosslinking monomers in the presence of a Lewis acid.

The most preferred polymer binder materials for the purposes of this invention are para-hydroxy styrene polymers or copolymers having a plurality of repeating units of the structure

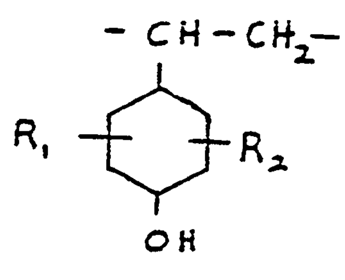

wherein $R_1$ and $R_2$ are independently selected from the group consisting of hydrogen, $C_1$ to $C_4$ alkyl, $C_1$ to $C_4$ haloalkyl $C_1$ to $C_4$ alkoxy and halogen.

Preferred of such polymers are poly p-hydroxystyrene, poly-(3-methyl-4-hydroxy) styrene and poly-(3,5-dimethyl-4-hydroxy) styrene, copolymers containing at least 50wt% of such hydroxy styrene monomers with other ethylenically unsaturated monomers such as styrene, alkyl acrylates and methacrylates, and the like may also be used.

Other polymers having free hydroxy groups present on an aromatic ring such as novolak resins may also be used as binder resins. Also suitable are blocked polymers and copolymers such as poly(p-tert butoxy-carbonyloxy styrene) and blocked copolymers of styrene and maleimide such as disclosed in US Patents 4,491,628 and 4,837,124 respectively, the disclosures of which are incorporated herein by reference.

In addition to the polymers described above, the photoresist composition of this invention also contains an addition polymerizable ethylenically unsaturated compound containing at least two terminal ethylenic groups, a photoinitiator and a solvent, and may optionally include stabilizers and other additives.

The photopolymerizable material of the photosensitive composition of the invention comprises an addition polymerizable, non-gaseous (boiling temperature above 100°C at normal atmospheric pressure), ethylenically-unsaturated compound containing at least two terminal ethylenic groups, and being capable of forming a high molecular weight polymer by free radical initiated, chain propagating addition polymerization. Suitable polymerizable materials non-exclusively include tetra ethylene glycol dimethacrylate, ethylene glycol dimethacrylate, trimethylol propane trimethyacrylate, trimethylol propane triacrylate, polyethylene glycol (200) diacrylate, polyethylene glycol (600) diacrylate, diethylene glycol dimethacrylate, pentaerythritol tetraacrylate, pentaerythritol triacrylacrylate, 1,4-butanediol diacrylate, 1,6-hexanediol dimethacrylate, dipentaerythritol monohydroxypentaacrylate, ethyoxylated bisphenol A dimethacrylate, tripropylene glycol diacrylate, tris(2-hydroxyethyl)isocyanurate trimethylacrylate, tris(2-hydroxyethyl)triacrylate, glycerol diacrylate, glycerol triacrylate, hexamethylene, diamine diacrylamide and mixtures thereof.

Photoinitiators suitable for use in the present invention are materials capable of the in-situ crosslinking polymerization of the ethylenically unsaturated monomers to form a cross-linked network after reaction with actinic radiation. The choice of photoinitiator is determined by several factors including the type of radiation to which sensitivity is desired. Clearly, the photoinitiator must absorb radiation at the frequency to be used, but it also must convert the radiation efficiently into polymerization starters.
Generally, the photoinitiator will have a boiling point of 150°-200°C or higher. It is desirable that the photoinitiator not be unstable at temperatures below about 90°C, to allow for the possibility of a baking step, the purpose of which is to remove the resist solvent.

Suitable photoinitiator compounds include the diazonium, iodonium and sulfonium salts disclosed in US Pat. Nos. 3,981,897 and 4,450,360 or organic compounds having carbon halogen bonds such as those of US Pat. Nos. 3,779,778, 3,515,552 and 3,536,489.

Iodonium salts preferably are diaryliodonium salts such as di-4-methylphenyliodonium, di-4-methyoxyphenyliodonium, and diphenyliodonium salts. Sulfonium salts preferably are triarylsulfonium salts such as tri-4-methylphenylsulfonium, tri-4-methoxyphenylsulfonium, and triphenylsulfonium salts. Most preferably, the iodonium or sulfonium salts are perfluoroalkane sulfonates, such as $C_1$ to $C_{10}$ straight chain alkane sulfonates such as perfluoropentane, perfluorooctane, and perfluoromethane sulfonates. The onium salts may also be haxafluorophosphates, tetrafluoroborates, or hexafluoroarsenates. Compounds particularly suitable for use in the present invention include 4-methylbenzenediazonium tetrafluoroborate, diphenyliodonium hexafluorophosphate, triphenylsulfonium perfluorooctanesulfonate, tribromotrichloroethane, 2,4-bis-(trichloromethyl)-6-p-methoxystyryl-s-triazine, and the like.

The onium salts may incorporate an anion capable of absorbing actinic radiation and transferring energy to the cation. Examples of such anions are 4-nitronaphthalene-1-sulfonate, 4-methoxynaphthalene-1-sulfonate or naphthoquinone sulfonate.

Another category of suitable photoinitiators is disclosed in US Pat. No. 4,464,457; 4,465,758 and 4,619,998 which are incorporated herein by reference. Examples are benzoin and its derivatives, trichloromethyl-s-triazines,
1,3-bistrichloromethyl-5-(para-biphenyl)triazine-2,4,6;
1,3-bistrichloromethyl-5-(parastilbenyl)triazine-2,4,6; 1,3-bistrichloromethyl-5-(4-ethoxy-1-naphthyl)triazine-2,4,6;carbonylmethyleneheterocyclic compounds containing trihalomethyl groups such as 2-(p-trichloromethylbenzoyl methylene)-3-ethyl benzothiazoline; acridine derivatives, such as, 9-phenylacridine, 9-p-methoxyphenylacridine, 9-acetylaminoacridine and benzylacridine. Other examples are phenazine derivatives, such as 9,10-dimethylbenz(a)phenazine and 10-methoxybenz(a)phenazine, quinoxaline derivatives such as, 6,4′,4″-trimethoxy-2,3-diphenylquinoxaline and 4′,4″-dimethoxy2,3-diphenyl-5-azaquinoxiline;
2,3-diphenyl-6-methylquinoxaline-1,4;
2,3-diphenyl-6-methoxyquinoxaline-1,4;
2,3-bis(para-methoxyphenyl)-6-methoxyquinoxaline-1,4;
2,3-bis(para-methoxy-phenyl)quinoxaline-1,4 and quinazoline derivatives.

The solvents suitable for preparation of resist solutions include the organic solvents not having free acid groups, for example, diglyme, dimethyl formamide, cyclohexanone, toluene, xylene, cellosolve acetate, propylene glycol methyl ether and the like.

Small amounts of basic substances such as trialkyl amines will stabilize the resist solution by virtue of their ability to scavenge traces of acid which might be present, or might be generated during storage. It is most advantageous if the basic substance is volatile so that it is easily removed from the resist film after coating on the substrate. This allows full sensitivity of the resist during subsequent processing. However, if for some reason a resist less sensitive to actinic light is desired, non-volatile basic substances which remain in the film to scavenge a portion of the generated photoacid may be beneficial.

In general, the photoresist compositions may contain from about 5 to about 70, preferably from about 10 to about 50, and more preferably from about 10 to about 30% by weight of ethylenically unsaturated polymerizable compounds based on the weight of polymer present in the composition. The photoinitiator may be employed at levels of from about 2 to about 25% by weight, more preferably from about 5 to about 20% by weight based on the weight of the ethylenically unsaturated polymerizable compounds present in the composition.

The amount of solvent used to prepare resist solution may generally be sufficient to provide solutions having a concentration of non-volatile components in the range of from about 10 to about 30% by weight, more preferably from about 15 to about 25% by weight.

The resist composition can be coated onto the substrate by one of several means known in the art, including spin coating, dip coating and roller coating. For purposes of microlithography, the optimum coating is from 0.5 to 2.5 micrometer in thickness and is applied by spin coating. After coating, the solvent may be removed by baking at a temperature from 35° to 100°C for 1 minute to 100 minutes. The resist film then may be exposed to actinic radiation through a mask to create a latent image. Although wavelengths of 230 nm to 500 nm may be used, for the preferred DUV (wavelengths of from 245 to 300 nm) exposure, 0.5 to about 350 mJ/cm$^2$ is appropriate.

Other suitable actinic radiation to which the composition according to the present invention is sensitive is any electromagnetic radiation whose energy is sufficient to initiate polymerization. Visible and ultraviolet light, x-rays and electron radiation are particularly suitable. Laser radiation in the visible and UV range can also be used.

The mixture may contain, as further conventional components, polymerization inhibitors, oxygen scavengers, hydrogen donors, sensitometric regulators, dyes, pigments, plasticizers and like additives.

Leuco bases of triarylmethane dyes may also be used in the present invention, including those of Crystal Violet, Victoria Blue BH, Victoria Pure Blue BOH, methyl Violet, Fuchsine, Malachite Green, Acid Violet 5B, Solar Cyanine 6B, Brilliant Green and Acilan Violet S.

Suitable substrates to which the photoresist composition may be applied include silicon, aluminum, glass, polymeric resin boards and films, silicon dioxide, doped silicon dioxide, silicon nitride, tantalum, copper, polysilicone ceramics and aluminum/copper mixtures.

Suitable alkali developers which can be employed to develop the resists include aqueous solutions of potassium hydroxide, sodium hydroxide, tetramethyl ammonium hydroxide, sodium meta silicate and like materials.

The following examples are illustrative of the invention.

Example 1

A photosensitive resist formulation was prepared by mixing the following ingredients:

| | | |
|---|---|---|
| Poly (p-hydroxy styrene)-($M_n$ -21,000) | - | 5.0 grams |
| Pentaerythritol triacrylate | - | 0.9 grams |
| Trichloro triazine | - | 0.1 grams |
| Diglyme | - | 19.0 grams |

The above ingredients were dissolved in solvent to form a clear solution which was filtered under pressure through a 0.45 micron Teflon membrane filter. The composition was then spun coated onto the surface of a 3 inch silicon wafer at 2000 RPM for 30 seconds, after which it was soft baked at 90°C for 30 minutes in an air oven to drive off the solvent.

The wafers were exposed to deep UV radiation (260 nm) through a chrome/quartz Optoline mask to a mercury vapor lamp from Hybrid Technology Group for 270 seconds with a bulk exposure energy of about 1426 mJ/cm$^2$. After exposure, the wafers were post exposure baked at 120°C for 5 minutes.

The wafers were then developed by dipping in a 0.1 N aqueous solution of potassium hydroxide for 140 seconds, followed by a rinse in deionized water. The developed wafers were once again baked at 150-155°C

for 15 minutes.

The developed wafers had a resist film thickness of 2.153 microns and a dark film loss of 0.09 microns. The resist photospeed was calculated as 27mJ/cm$^2$ and had a contrast of 1.58. The resist remaining on the wafer was well adhered and the wafer exhibited no scum and fine resolution, and no thermal flow at 150-155°C.

Example 2

A photosensitive resist formulation was prepared by mixing the following components:

| | | |
|---|---|---|
| Poly(p-hydroxystyrene) -( Mn - 21,000) | - | 3.75 grams |
| Pentaerythritol triacrylate | - | 0.75 grams |
| Diphenyl iodonium triflate | - | 0.10 grams |
| Diglyme | - | 20.40 grams |

The above ingredients were dissolved in solvent to form a clear solution.

Wafers were coated and processed as in Example 1, except for the following conditions:

Spin coat at 2500 RPM

Exposure at 260 nm at about 300 mJ/cm$^2$

Post exposure bake at 110°C for 10 minutes

Developer is 0.15N aqueous KOH for 90 seconds.

The developed wafers had an undeveloped resist thickness of 0.94 microns, a resist photospeed of 15 mJ/cm$^2$, a contrast of 2.95, and a dark film loss of 0.006 microns. The undeveloped resist had good adhesion to the substrate and showed fine resolution and no scum.

The invention has been described by way of the above specification and illustrative examples and it is to be understood that this invention is not limited to the specific embodiments thereof except as defined by the following claims.

## Claims

1. A negative-acting, base-developable photoresist composition comprising a mixture of:
   a. a polymeric film-forming binder material which when formed into a thin film is soluble in an aqueous alkali solution;
   b. a photopolymerizable compound containing at least two terminal ethylenically unsaturated groups; and
   c. a photoinitiator which catalyzes the cross linking of said photopolymerizable compound upon exposure to actinic radiation to form an alkali-insoluble resinous network;
   said polymeric binder material being further characterized that it is free of ethylenic unsaturation and free of substituent groups capable of reacting with said photopolymerizable material in the presence of a Lewis acid.

2. The composition of claim 1 wherein said polymeric binder material is a polymer or copolymer of para-hydroxystyrene having the formula:

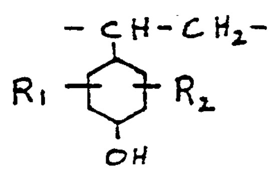

wherein $R_1$ and $R_2$ are independently selected from hydrogen, $C_1$ to $C_4$ alkyl, $C_1$ to $C_4$ haloalkyl, $C_1$ to $C_4$ alkoxy and halogen.

3. The composition of claim 2 wherein said polymeric binder material is poly (para-hydroxystyrene).

4. The composition of claim 1 or 2 wherein said photopolymerizable compound is pentaerythritol triacrylate.

5. The composition of any of claims 1-4 wherein said photoinitiator is benzoin or a trihalo triazine derivative thereof.

6. The composition of claim 5 wherein said photoinitiator is trichloro triazine.

7. The composition of any of claims 1-4 wherein said photoinitiator is an onium salt.

8. The composition of claim 7 wherein said onium salt is diphenyl iodonium triflate.

9. The composition of any of claims 1-8 containing from 5 to 70% by weight of said photopolymerizable compound based on the weight of polymer present in the composition and from 2 to 25% by weight of said photoinitiator based on the weight of said photopolymerizable compound present in the composition.

10. The composition of claim 9 dissolved in organic solvent at a concentration of from 10 to 30% by weight.

11. A process for forming a negative photoresist image comprising:
   a. forming a thin film of the composition of any of claims 1-9 on a substrate;
   b. imagewise exposing said film to a pattern of actinic radiation; and
   c. removing the non exposed areas of said film by contact with aqueous alkali developer solution.

12. The process of claim 11 wherein said radiation is within the deep ultraviolet region of from 200 to 300 nm.